# EUROPEAN PATENT APPLICATION

(11) **EP 4 766 123 A1**
(43) Date of publication of application: **24.06.2026**
(21) Application number: 24307211.3
(22) Date of filing: 19.12.2024
(51) Int. Cl.: H10N 60/01, H10N 69/00

(54) **METHOD FOR PREPARING A SAMPLE FOR MANUFACTURING A SUPERCONDUCTING QUANTUM CIRCUIT COMPRISING A JOSEPHSON JUNCTION**

(71) Applicant: Alice & Bob, 75015 Paris (FR)
(72) Inventor: Cardoso, Gil, 75015 PARIS (FR); Solard, Jeanne, 75015 Paris (FR)
(74) Representative: Atout PI Laplace

(57) **Abstract**

A method for preparing a sample for manufacturing a superconducting quantum circuit comprising a Josephson junction, said sample comprising a substrate layer covered by an undercut resist layer and a top resist layer, said method comprising:
- providing an undercut resist layer made from an electron-beam-lithography (EBL)-insensitive selectively soluble material,
- providing a top resist layer made from a positive-EBL-sensitive material on top of said undercut resist layer,
- receiving (200) a superconducting quantum circuit pattern comprising a Josephson junction,
- determining (210) a corrected pattern by applying a 2D Proximity Effect Correction to said superconducting quantum circuit pattern,
- projecting (220) at least 50 kV electron beam on the top resist layer modulated according to said corrected pattern,
- developing (230) the top resist layer,
- developing (240) the undercut resist layer.

## Description

The invention concerns a method for preparing a sample for manufacturing a superconducting quantum circuit, in particular comprising a Josephson junction. The invention also concerns a sample prepared with this method, a method for manufacturing a superconducting quantum circuit using the sample, as well as a superconducting quantum circuit produced by the manufacturing method.

A known method for fabricating a superconducting quantum circuit pattern with a Josephson junction on a substrate layer is the shadow evaporation technique. This technique includes preparing a sample comprising the substrate layer and a suspended mask, and coating a superconducting layer on the substrate layer through the suspended mask.

The suspended mask is generally made of two or more resist layers. A conventional suspended mask comprises a first resist layer, or undercut resist layer, made of MMA (for Methyl methacrylate) and provided over the substrate layer, and a second resist layer, or top resist layer, made of PMMA (for Poly(methyl methacrylate)) and provided over the undercut resist layer.

The suspended mask presents a bridge-like structure, so that the coating of the superconducting layer over the sample results in depositing the superconducting quantum circuit in a pattern on the substrate layer corresponding to the shadow cast by the bridge-like structure. Changing the angle at which the superconducting material is deposited allows to modify the extent of the shadow, and different depositions at different angles enable the fabrication of particular superconducting elements such as Josephson junctions. For instance, by tilting the substrate layer at two different angles during successive depositions of the superconducting material, with an intermediate step of oxidation to grow an insulating layer (e.g. aluminium oxide), a precise overlap of the superconducting layers is provided with an insulating layer therebetween, all together forming the Josephson junction. This method is effective in producing, well-defined Josephson junctions or arrays thereof, often used in superconducting qubits for quantum computing.

Conventionally, the bridge-like structure of the suspended mask is achieved by applying electron beams over the sample during an EBL (for electron beam lithography) operation, and by developing the resist layers.

An ongoing difficulty of the EBL operation is that the beam electrons interact with the MMA/PMMA resist layers and with the substrate layer, which impacts the shape and resistance of the bridge-like structure and finally results in fabrication of a superconducting quantum circuit wider than the superconducting quantum circuit pattern, and/or leads to a collapse of the patterned circuit. More generally, this effect causes features to blur or merge, especially in densely packed circuits - for instance when arrays of Josephson junctions are required to be positioned relatively close to other features such as large conducting pads of a capacitive element.

In order to compensate for this effect, called proximity effect, a PEC (for Proximity Effect Correction) method can be implemented. The PEC method comprises calculating a corrected pattern based on the superconducting quantum circuit pattern. The corrected pattern is used, in particular, to modulate the energy dose of electron beams applied to the sample during the EBL operation, in order to limit the unwanted impacts of these beams on the bridge-like structure and finally fabricate, on the substrate layer, a superconducting quantum circuit which corresponds to the superconducting quantum circuit pattern.

Conventional manufacturing methods used EBL system using 30kV beams. Due to the strong forward scattering (enlargement of the exposed area inside the resist at small angles) with 30 kV, PEC was regarded as a good method to improve the fabrication process.

However, modern manufacturing methods rely on higher voltages such as between 50kV and 150kV (even up to 200kV) beams, in particular 100kV beams. It is usually considered that the passage from 30kV beams to 100kV beams removes the need of PEC methods, because the forward scattering of the 100kV beam is low.

However, the Applicant discovered that it is not the case, especially when fabricating Josephson junctions requiring large (e.g. wide) or fragile bridge-like structures. More precisely, the Applicant discovered that, due to the back scattering (enlargement of the exposed area inside the resist at large angles) being strong, 100kV beams are actually very detrimental to the neighbouring bridge-like structures, which end up being mechanically weak and often collapse during the manufacturing process. This problem is particularly felt in the case where the bridge-like structures are located in the vicinity of large structures (such as relatively large capacitive pads). As a result, the Applicant explored applying PEC to a conventional sample comprising MMA/PMMA resist layers. However, this proved to be unproductive, because it required to implement a 3D PEC method difficult to handle and giving inconsistent results.

The invention aims at improving the situation. To this end, the Applicant proposes a method for preparing a sample for manufacturing a superconducting quantum circuit comprising a Josephson junction, said sample comprising a substrate layer covered by an undercut resist layer and a top resist layer, said method comprising:
- providing an undercut resist layer made from an electron-beam-lithography (EBL)-insensitive selectively soluble material,
- providing a top resist layer made from a positive-EBL-sensitive material on top of said undercut resist layer,
- receiving a superconducting quantum circuit pattern comprising a Josephson junction,
- determining a corrected pattern by applying a 2D Proximity Effect Correction to said superconducting quantum circuit pattern,
- projecting at least 50 kV electron beam on the top resist layer modulated according to said corrected pattern,
- developing the top resist layer,
- developing the undercut resist layer.

As the material used in the undercut resist layer is not sensitive to EBL, it is no longer necessary to take the undercut resist layer into account for the PEC. A 2D PEC method can be implemented, which is much easier to handle than a 3D PEC method and enables to achieve consistent results. The method according to the invention also presents the advantage of enabling to fabricate samples of which suspended masks comprise longer bridges, and thus to fabricate more diversified superconducting quantum circuits.

In various embodiments, the method may present one or more of the following features:
- the EBL-insensitive selectively soluble material is chosen from a group comprising LOR, PMGI, AR-BR 5400, MICROPOSIT LOL 2000 and/or MICROPOSIT LOL 1000, and wherein the positive-EBL-sensitive material is chosen from a group comprising PMMA, CSAR62, and/or ZEP,
- the EBL-insensitive selectively soluble material is made of LOR and the positive-EBL-sensitive material is made of PMMA,
- projecting at least 50 kV electron beam comprises using at least 100 kV electron beam,
- developing the top resist layer comprises using one of MIBK, IPA and MIBK mixture and IPA and deionised water mixture,
- developing the undercut resist layer comprises prewetting the top resist layer and/or using a TMAH-based developer for precise etching,
- providing a top resist layer further comprises applying a discharging layer over the top resist layer,
- the method further comprises depositing a superconducting layer after developing the undercut resist layer, optionally using a two-step angled coating process, and
- providing an undercut resist layer comprises using a primer on the substrate layer and/or using a spin-coating process,

The invention further concerns a method having the above features for preparing a sample for manufacturing a superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm, a distal end of said Josephson junction array being between 0.75 µm and 50 µm from a conductive structure on the sample, wherein the conductive surface has a surface area greater than 100 µm².

The invention further concerns a method of manufacturing a superconducting quantum circuit, comprising using a sample prepared according to any of the preceding claims to fabricate Josephson junctions in a part of the superconducting quantum circuit by double angle evaporation.

The invention further concerns a sample for manufacturing a superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm or greater than 5 µm, a distal end of said Josephson junction array being between 0.75 µm and 50 µm from a conductive structure on the sample, wherein the conductive surface has a surface area greater than 100 µm².

The invention further concerns a superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm or greater than 5 µm, a distal end of said Josephson junction array being between 0.75 µm and 50 µm from a conductive structure on the sample, wherein the conductive surface has a surface area greater than 100 µm².

In this superconducting quantum circuit, the Josephson junction array may comprise between 10 and 55 Josephson junctions, the Josephson junctions are between 4 µm and 5 µm widen, and the distal end of the Josephson junction array is less than 10 µm from a conductive pad, and the conductive pad is at least 20 µm wide in direction perpendicular to an axis defined by the Josephson junction array and at least 10 µm long in direction parallel to the axis defined by the Josephson junction array.

This superconducting quantum circuit may comprise an asymmetrically threaded SQUID having a central superinductor comprised of said Josephson junction array.

Thus, the present invention enables manufacture of complicated structures such as arrays of Josephson junctions having particularly wide spans (i.e. in the in-plane direction perpendicular to axis of the array) and which are positioned close to relatively large conducting elements. These arrays of Josephson junctions provide for higher quality "superinductors" ) with a smaller footprint. Indeed, the wider Josephson junctions result in a lower resistance, higher critical currents, and reduced charging energy, thereby driving the system toward a more classical regime with potentially less quantum coherence and more pronounced supercurrent behavior, whilst being able to be positioned closer to other conducting elements to reduce the footprint. As an example, this can be particularly useful for the central superinductor of a so-called asymmetrically threaded SQUID (ATS), wherein the branch of the ATS comprising the superinductor may be reduced in total length whilst ensuring the superinductor still reaches targeted critical currents, thereby decreasing the area of each loop of the ATS and correspondingly reducing the undesirable sensitivity to flux noise.

Other features and advantages of the invention will readily appear in the following description of the drawings, which show exemplary embodiments of the invention and on which:
- Figure 1 is a cross-sectional view of a sample for use in the method according to the invention,
- Figure 2 is a flowchart presenting the operations of an embodiment of the method according to the invention,
- Figure 3 is a schematic top view of a superconducting quantum circuit pattern received as an input in the embodiment of Figure 2,
- Figure 4 is a schematic top view of a corrected pattern obtained after implementing the 2D PEC operation of the embodiment of Figure 2,
- Figure 5 is a cross-sectional view of the sample of Figure 1 after implementing the EBL exposure operation of the embodiment of Figure 2,
- Figure 6 is a cross-sectional view of the sample of Figure 1 after implementing the first developing operation of the embodiment of Figure 2,
- Figure 7 is a cross-sectional view of the sample of Figure 1 during the second developing operation of the embodiment of Figure 2,
- Figure 8 is similar to Figure 7,
- Figure 9 is similar to Figure 7,
- Figure 10 is a cross-sectional view of the sample of Figure 1 after implementing the second developing operation of the embodiment of Figure 2,
- Figure 11 is a top view of a Josephson junction array obtained with a sample prepared with the method according to the invention,
- Figure 12 is a top view of a Josephson junction array obtained with a sample prepared with a state-of-the-art method,
- Figure 13 shows an image of a junction with a collapsed bridge structure,
- Figure 14 shows an image of a junction with a collapsed bridge structure at the end of the array close to a conductive pad structure,
- Figure 15 shows an image of a superconducting quantum circuit fabricated according to the invention,
- Figure 16 shows a close-up of Figure 15, and
- Figure 17 shows a close-up of Figure 15 at the lower end of the Josephson junction array close to the lower conductive pad.

The drawings and the following description are comprised for the most part of positive and well-defined features. As a result, they are not only useful in understanding the invention, but they can also be used to contribute to its definition, should the need arise.

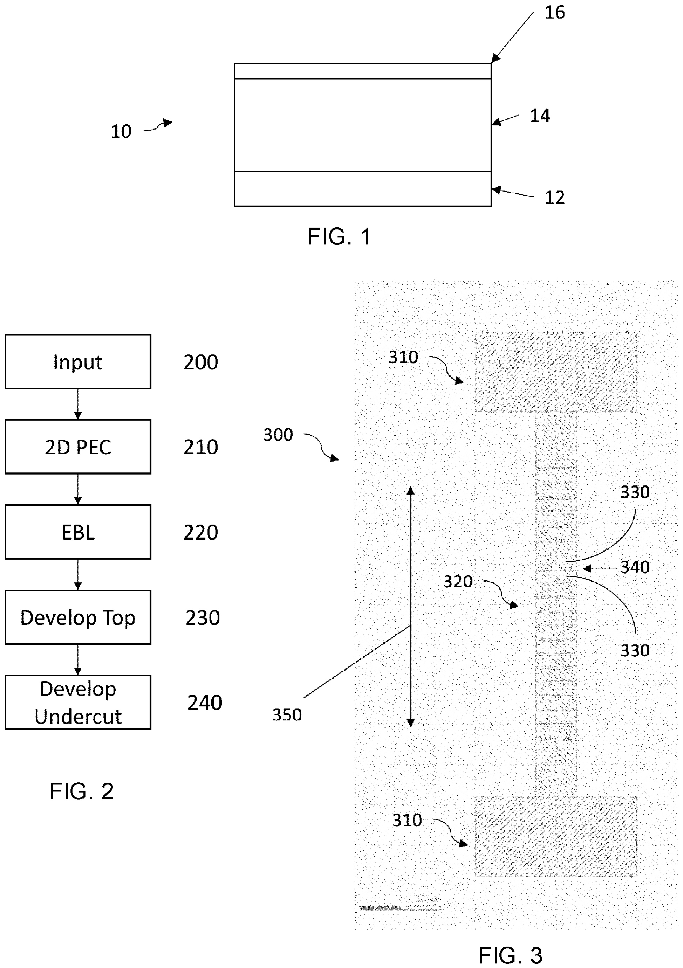

Figure 1 shows a sample 10 used for carrying out a method according to the invention. The sample 10 comprises a substrate layer 12 for a superconducting quantum circuit. The substrate layer 12 can be made of a single layer of material. As a variant, the substrate layer 12 can be made of several underlayers of various materials. The materials used in the substrate layer 12 can be conducting or insulating. The materials used in the substrate layer 12 can be chosen among any superconducting metal and non-conductive material. Here, the substrate layer 12 consists in a single layer of silicon. Of course, other materials could be used, such as sapphire for instance.

The sample 10 further comprises a first resist layer, or undercut resist layer 14, arranged over the substrate layer 12. The undercut resist layer 14 can be made of a single layer of material. As a variant, the undercut resist layer 14 can be made of several underlayers of various materials. The materials used in the undercut resist layer 14 are not sensitive to electron beam lithography (EBL) and which are selectively soluble in specific developers. Such materials may be termed EBL-insensitive (for electron-beam-lithography-insensitive) selectively soluble materials.

The materials used in the undercut resist layer 14 can be chosen among LOR, PMGI, AR-BR 5400 (including its variants AR-BR 5460 and AR-BR 5480) and/or MICROPOSIT LOL 2000 (or its variant MICROPOSIT LOL 1000). Here, the undercut resist layer 14 consists in a single layer of LOR. A description of LOR (Lift-Off Resist) can be found at https://amolf.nl/wp-content/uploads/2016/09/datasheets_LOR_datasheet.pdf. A description of PMGI can be found at https://kayakuam.com/wp-content/uploads/2023/06/KAM-LOR-PMGI-Datasheet-4.30.24-final.pdf. A description of AR-BR 5400 can be found at https://www.allresist.com/wp-content/uploads/sites/2/2020/03/AR-BR5400_english_Allresist_product_information.pdf. A description of MICROPOSIT LOL 2000 can be found at https://www.microresist.de/en/produkt/microposit-lol2000-lift-of-layer/.

In conventional methods, the undercut resist layer 14 was made of MMA (for Methyl methacrylate), the disadvantages of which will appear below. This choice of material for the undercut resist layer 14 is not accidental. Quite the opposite, it is an essential part of the invention, as it allows to use a specific PEC (for Proximity Effect Correction) method.

The sample 10 further comprises a second resist layer, or top resist layer 16, arranged over the undercut resist layer 14. The top resist layer 16 can be made of a single layer of material. As a variant, the top resist layer 16 can be made of several underlayers of various materials. The materials used in the top resist layer 16 are sensitive to EBL (termed EBL-sensitive material). The materials used in the top resist layer 16 can be chosen among any positive electron beam resist. Non-limiting examples include PMMA, CSAR62, and ZEP. Here, the top resist layer 16 consists in a single layer of PMMA (for Poly(methyl methacrylate)). Generic information concerning PMMA are readily available.

Commercial products which may be used include AR-P 630 - 670 (https://www.allresist.com/wp-content/uploads/sites/2/2020/03/AR-P630-670_english _Allresist_product-information.pdf), Kayaku PMMA Positive resist (https://kayakuam.com/products/pmma-positive-resists/), Micro Resist PMMA / Copolymer series (https://www.microresist.de/en/produkt/pmma-copolymer-series/).

When the materials used in the substrate layer 12 are insulating, the sample 10 can further comprise a discharging layer, arranged over the top resist layer 16. The materials used in the discharging layer can be chosen among metals, conductive polymers, germanium.

As will appear below, the undercut resist layer 14 bears this name because it is meant to be the object of material removal (or developing) underneath the top resist layer 16. The combination of the undercut resist layer 14 and the top resist layer 16 allows to provide complex 3D structures for the sample 10.

Providing the sample 10 can be done in various manners.

For example, providing the undercut resist layer 14 over the substrate layer 12 can comprise the following steps:
- cleaning the substrate layer 12,
- dehydrating the substrate layer 12,
- spincoating the material of the undercut resist layer 14 over the substrate layer 12,
- baking the undercut resist layer 14.

For example, providing the top resist layer 16 over the undercut resist layer 14 can comprise the following steps:
- spincoating the material of the top resist layer 16 over the undercut resist layer 14,
- baking the top resist layer 16.

Figure 2 shows a diagram of operations performed during the execution of an embodiment of a method according to the invention.

In a first operation 200, the method begins with the input of a pattern to be imaged on a sample in view of obtaining a superconducting quantum circuit.

This pattern is a complete scheme or a portion of a superconducting quantum circuit which is intended for manufacture. In various embodiments, the received pattern may represent a complete circuit, in which case the sample is prepared in one-shot, or it may be prepared by imaging the circuit scheme portion by portion, in which case each input represents a portion of the circuit to be printed.

The invention is particularly advantageous when Josephson junctions have to be patterned, as they require providing a bridge-like sample structure, also called Dolan bridge. Other methods can be used to provide a Josephson junction, but the invention is particularly useful when it is necessary to use a fabrication method that relies on bridge-like structure, that is in which significant portions of the undercut resist layer 14 need to be developed, hence potentially having mechanical resistance issues, or other risks of breaks.

As a result, in the following, the notion of input pattern will always be seen as comprising one or more Josephson junctions which require a bridge to be imaged in the sample. More generally, the expressions "circuit pattern", "superconducting quantum circuit pattern" and "Josephson junction pattern" will be considered as equivalent as they represent the pattern which is intended to be printed (or imaged) in order to provide a superconducting quantum circuit once the printed substrate is covered with a superconducting layer. The skilled person can readily distinguish between a Josephson junction or an array of Josephson junctions formed by the Dolan bridge technique as opposed to other techniques such as the Manhattan process.

Figure 3 shows an example of a Josephson junction pattern 300 received as an input in the first operation 200. As explained above, the Josephson junction pattern 300 corresponds to a pattern intended to be imaged on the substrate layer 12 of the sample 10 of Figure 1 by a combination of various actions exposing portions of the substrate layer 12. These actions can include performing a superconducting layer coating operation, which will cover only the remaining portions of the top resist layer 16, the undercut resist layer 14, and the exposed portion of the substrate layer 12. The superconducting quantum circuit will be formed by the shape of the deposited superconducting layer.

Conventionally, a Josephson junction comprises two superconducting layers separated by a non-superconducting layer. Each superconducting layer can be made from a single layer of material. As a variant, one or both of the superconducting layers can be made of several underlayers of various materials. The materials used in the superconducting layers can be chosen among any superconducting metals (which are superconducting at temperatures lowers than a particular threshold). Examples include Aluminium, Niobium, etc. The non-superconducting layer can be made of a single layer of material or of several underlayers of various materials. The materials used in the non-superconducting layers can be chosen among any insulating materials. Conventionally, a Josephson junction presents a three-layer Al/Al₂O₃/Al structure.

The Josephson junction pattern 300 can comprise one or several Josephson junctions. These Josephson junctions can be of various sizes and geometries. For example, the Josephson junctions can measure from 50 nm to 6 µm (this value corresponding to the width of the bridge of a remaining top resist layer over an empty portion of undercut resist layer). Preferably, the width of the Josephson junctions is between 3.5 µm and 6 µm, and most preferably between 4 µm and 5.5 µm, for instance greater than 5.3 µm. The present Inventors have discovered that Josephson junctions having width greater than 5 µm is particularly advantageous.

The Josephson junction pattern 300 can further comprise capacitive pads. These capacitive pads can be of various sizes and geometries. For example, the capacitive pads can measure from a few dozen to a few hundred micrometres.

In the example shown on Figure 3, the Josephson junction pattern 300 presents dark hatched areas, which represent the portions of the substrate layer 12 which will be exposed to receive the superconducting layer.

Here, the Josephson junction pattern 300 comprises a pair of capacitive pads 310, mutually opposite. Typically, each capacitive pad 310 presents a generally rectangular shape. Here, each capacitive pad 310 presents a shorter side of about 20 µm and a longer side of about 40 µm.

Here, the Josephson junction pattern 300 further comprises a Josephson junction array 320, connecting the two capacitive pads 310 together. Here, the Josephson junction array 320 presents a width of about 5 µm.

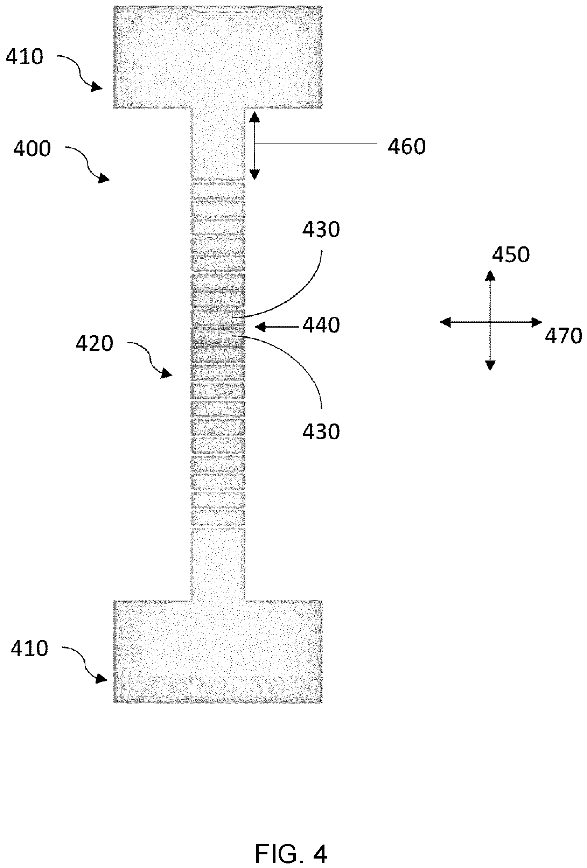

As will be appreciated, a Josephson junction array comprises a plurality of Josephson junctions extending in a substantially linear manner (namely, along an axis direction such as 350 indicated in Figure 3). The Josephson junction array may comprise at least 3 Josephson junctions, preferably between 5 and 55 Josephson junctions, and most preferably between 10 and 20 Josephson junctions. The number of Josephson junctions will be selected depending on the desired functionalities of the array, such as to form a so-called superinductor having a target value of critical current etc. As an example, the arrays shown in Figures 3 and 4 are comprised of 20 Josephson junctions.

The Josephson junction array 320 comprises a plurality of adjacent exposed substrate layer portions 330 meant to be coated with the superconducting layer. These exposed substrate layer portions 330 are separated from one another by top resist layer portions 340 which are to be removed after the superconducting layer has been coated.

As a result, once the top resist layer is removed, what remains is the substrate layer 12, which is coated with the superconducting layer only on the exposed substrate layer portions 330. The remainder of the substrate layer 12 is exposed and forms a ground plane.

The coated portions thus form the pattern of the superconducting quantum circuit. Hence, one can view that the dark hatched portions of the Josephson junction pattern 300 substantially correspond to the pattern of the superconducting quantum circuit.

Once the Josephson junction pattern 300 of the first operation 200 is received, the method comprises a step of correcting the Josephson junction pattern 300. This step is quite unusual.

Conventional manufacturing methods relied on a top resist layer made of PMMA combined with an undercut resist layer made of MMA, imaged by means of an EBL using 30kV beams. Due to the strong forward scattering (enlargement of the exposed area inside the resist at small angles) with 30 kV, PEC was regarded as a good method to improve the fabrication process.

However, modern manufacturing methods rely on higher voltages such as between 50kV and 150kV (even up to 200kV) beams, in particular 100kV beams. It is usually considered that the passage from 30kV beams to 100kV beams removes the need of PEC methods, because the forward scattering of the 100kV beam is low.

However, the Applicant discovered that it is not the case, especially when fabricating Josephson junctions requiring large (e.g. wide) or fragile bridge-like structures. More precisely, the Applicant discovered that, due to the back scattering (enlargement of the exposed area inside the resist at large angles) being strong, 100kV beams are actually very detrimental to the neighbouring bridge-like structures, which end up being mechanically weak and often collapse during the manufacturing process. This problem is particularly felt in the case where the bridge-like structures are located in the vicinity of large structures (such as relatively large capacitive pads). As a result, the Applicant explored applying PEC to a conventional sample comprising MMA/PMMA resist layers. However, this proved to be unproductive, because it required to implement a 3D PEC method difficult to handle and giving inconsistent results.

However, this proved to be unproductive. The Applicant then had the idea to replace MMA by a material insensitive to the EBL beam, so as to enable 2D PEC.

This 2D PEC is performed in the second operation 210, and the result is shown on Figure 4. Figure 4 shows a corrected Josephson junction pattern, or corrected pattern 400, obtained from the Josephson junction pattern 300 of Figure 3. Each element of the corrected pattern 400 which corresponds to an element of the Josephson junction pattern 300 is referenced with the same reference number, increased by 100.

The corrected pattern 400 is obtained from the Josephson junction pattern 300 by applying the 2D PEC. The corrected pattern 400 corresponds to a pattern to be used by the EBL. In particular, the energy dose of the EBL is modulated according to the corrected pattern 400. On Figure 4, the darker areas correspond to higher energy doses (higher modulation), whereas the lighter areas correspond to lower energy doses (lower modulation). Hence, the corrected pattern 400 not only indicates where the EBL should be applied, but also in which quantity.

As described above, the undercut resist layer 14 of the sample 10 is not sensitive to EBL. Consequently, unlike the 3D PEC, the 2D PEC does not require to take into account the effect of the EBL on the undercut resist layer 14. The 2D PEC only requires to take into account the effect of the EBL on the top resist layer 16. It should be noted that the 2D PEC will depend not only on the pattern being imaged (for example, imaging of the big pads will strongly influence the 2D PEC on the Josephson junction bridges), but also on the EBL system itself. To some extent, the 2D PEC is dependent on the materials used and their thickness (substrate, superconducting layer, resists). If there was a manner to determine the 2D PEC independently from the particular EBL system, then operation 210 would likely become optional and/or would be integrated with operation 200.

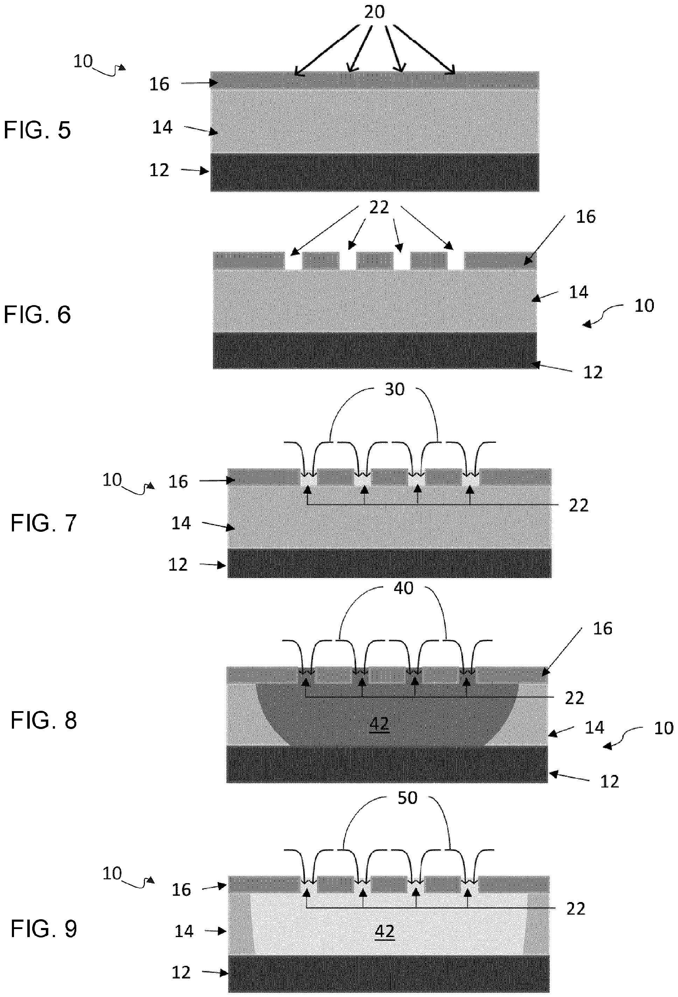

After the corrected pattern 400 has been determined, the actual imaging starts to take place. This is first performed in a third operation 220 of imaging the corrected pattern 400 on the top resist layer 16 with the EBL. The result of the third operation 220 is shown on Figure 5.

The third operation 220 comprises exposing the sample 10 in the EBL system and projecting a modulated 100 kV electron beam on the top resist layer 16 according to the corrected pattern 200. The modulated 100 kV electron beam is projected on areas, or exposed areas 20, of the top resist layer 16.

After imaging the corrected pattern 400 on the top resist layer 16 with the EBL, the method comprises a fourth operation 230 of developing the top resist layer 16. The result of this fourth operation 230 is shown on Figure 6.

Developing the top resist layer 16 comprises submerging the sample 10 in a first liquid developer. The first liquid developer can be chosen among MIBKand MIBK mixture and IPA and deionised water mixture. Here, the first liquid developer is a mix of IPA and deionized water. The first liquid developer removes the areas of the top resist layer 16 which were previously exposed to EBL by dissolving it, i.e. the exposed areas 20, forming through bores 22 on the top resist layer 16. These through bores 22 image on the top resist layer 16 a pattern corresponding to the corrected pattern 400.

When the sample 10 further comprises the discharging layer, the first liquid developer or a separate removing solution may be used to further remove the discharging layer.

As the undercut resist layer 14 is not sensitive to EBL, the undercut resist layer 14 is not etched by the first liquid developer.

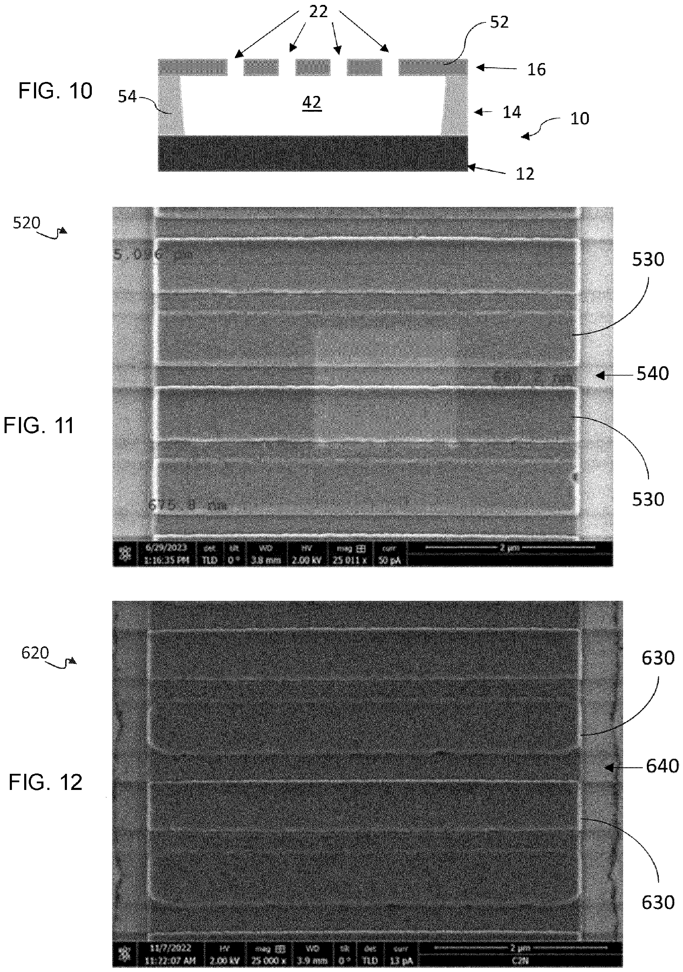

After developing the top resist layer 16, the method according to the invention further comprises a fifth operation 240 of developing the undercut resist layer 14. This fifth operation 240 is shown on Figures 7 to 9. The result of this fifth operation 240 is shown on Figure 10.

Developing the undercut resist layer 14 can firstly comprise prewetting the through bores 22 of the top resist layer 16, as shown on Figure 7. Prewetting the top resist layer 16 consists in submerging the sample 10 in deionized water. The deionized water flow is represented by the arrows 30. Prewetting the through bores 22 presents the effect of improving the homogeneity of the development of the undercut resist layer 14.

Developing the undercut resist layer 14 further comprises submerging the sample 10 in a second liquid developer, as represented on Figure 8. The second liquid developer flow is represented by the arrows 40. The second liquid developer selectively develops the undercut resist layer 14 without developing the top resist layer 16. The second liquid developer can be chosen among any TMAH (for Tetramethylammonium hydroxide) based developers. Here, the second liquid developer is AZ2026 MIF.

When submerging the sample 10 in the second liquid developer, the second liquid developer passes through the through bores 22 and reaches the undercut resist layer 14. The second liquid developer starts etching the undercut resist layer 14 in an isotropic manner, forming a cavity 42 in the undercut resist layer 14. The cavity 42 is filled with the second liquid developer.

Developing the undercut resist layer 14 further comprises submerging the sample 10 in deionized water, as represented on Figure 9. The deionized water flow is represented by the arrows 50. The deionized water flow passes through the through bores 22 and reaches the cavity 42 filled with the second liquid developer. The deionized water flow dilutes and neutralizes the second liquid developer, thereby stopping the etching of the undercut resist layer 14.

At the end of the fifth operation 240, as shown on Figure 10, the top resist layer 16 and the undercut resist layer 14 form together a suspended mask with a bridge-like structure. The bridge-like structure comprises bridges 52 formed in the top resist layer 16. The bridge-like structure images the corrected pattern 400. The bridge-like structure further comprises piles 54 formed in the undercut resist layer 14. The piles 54 support the bridges 52 at a distance from the substrate layer 12.

After the fifth operation 240, the sample 10 can undergo a conventional superconducting layer coating operation, as described above.

The method according to the invention enables to achieve a large range of dimensions and geometries of Josephson junctions with simple operations. The 2D PEC implemented in the method according to the invention is much easier to handle than a 3D PEC taking into account the effect of the EBL on both the top and undercut resist layers. In particular, the 2D PEC enables to reliably correct proximity effects resulting from large superconducting structures, such as capacitive pads. It is therefore possible to realise with a same exposure a superconducting quantum circuit mixing small structures, such as nanometric Josephson junctions, fragile structures, such as large Josephson junction arrays, and large structures, such as capacitive pads.

In particular, the present invention enables the fabrication of Josephson junction arrays comprised of relatively wide Josephson junctions (i.e. in the direction perpendicular to the array axis, e.g. perpendicular to 350 in Figure 3), and moreover wherein at least one end of the array is able to be positioned relatively close to a conductive pad. For instance, the double arrow 460 in Figure 4 indicates the distance between an end of the array 420 and the conductive pad 410. It will be appreciated that the end of the array may be electrically connected to the conductive pad 410, however this is not a requirement. What is important for fabrication purposes is the distance from the end of the array 420 to the pad 410, irrespective of whether an electrical connection is provided therebetween.

The method of the present invention enables a distal end (or both distal ends) of the Josephson junction array 420 to be positioned at least 0.75 µm from a conductive pad 410 (that is, the arrow 460 in Figure 4 indicates a length of at least 0.75 µm) and less than 50 µm from a conductive pad 410. Preferably, a distal end of the Josephson junction array 420 may be positioned between 1 µm and 10 µm from a conductive pad 410. Most preferably, a distal end of the Josephson junction array 420 may be positioned between 1 µm and 3 µm from a conductive pad 410.

Moreover, the present invention enables relatively large conductive pads to be fabricated, whilst still enabling the position of an end of a Josephson junction array close to the pad 410. For instance, conductive pads 410 may any size, conceivably be up to 200 µm wide (in the direction perpendicular to the array 420 axis, given by arrow 470 in Figure 4) and up to 200 µm long (in the direction parallel to the array 420 axis, given by arrow 450 in Figure 4), or even larger. Preferably, the conductive pads are between 20 µm and 100 µm wide and between 10 µm and 60 µm long. Most preferably, the conductive pads are between 50 µm and 80 µm wide and between 10 µm and 20 µm long. What is important here is that the conductive pads 410 may be fabricated with a relatively large surface area. For instance, the conductive pad may have a surface area of at least 100 µm², such as between 100 µm² and 5000 µm², and preferably between 400 µm² and 1000 µm².

Figure 11 shows a part of a Josephson junction array, or resulting Josephson junction array 520, obtained with a sample prepared with the method according to the invention. The resulting Josephson junction array 520 presents a plurality of adjacent superconducting layers 530, separated from one another by non-superconducting layers 540. The adjacent superconducting layers 530 correspond to the exposed substrate layer portions 330 of the Josephson junction pattern 300. The non-superconducting layers 540 correspond to the top resist layer portions 340 of the Josephson junction pattern 300.

Here, the resulting Josephson junction array 520 presents a width of about 5 µm. Each adjacent superconducting layers 530 presents a generally rectangular shape, with a longer side of about 5 µm, corresponding to the width of the resulting Josephson junction array 530, and a shorter side of about 1.5µm. . The overlapping of the adjacent superconducting layers results in a junction having a 650 nm to 700 nm size due to the fact that the superconducting layer is coated in a two steps process, each time at an angle.

For comparison, Figure 12 shows a state-of-the-art Josephson junction array 620, of which dimensions are similar to the ones of the resulting Josephson junction array 520. The state-of-the-art Josephson junction array 620 is made from a sample comprising MMA as undercut resist layer, as previously described. The state-of-the-art Josephson junction array 620 presents a plurality of adjacent superconducting layers 630, separated from one another by non-superconducting layers 640.

The comparison between Figure 11 and Figure 12 highlights the efficiency of the method according to the invention to prepare a sample intended for imaging a fragile structure such as a large Josephson junction array. In the state-of-the-art Josephson junction array 620, the superconducting layers 630 are not fully cleared, whereas in the resulting Josephson junction array 520, the superconducting layers 530 are very neatly printed.

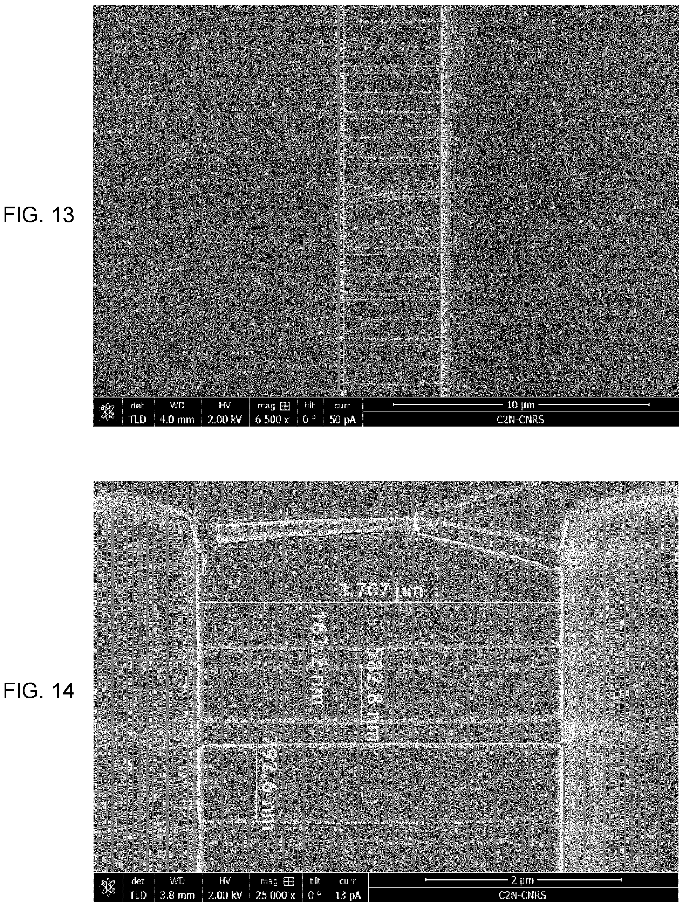

Figure 13 shows an image of a junction with a collapsed bridge structure towards the centre of the array. Figure 14 shows an image of a junction with a collapsed bridge structure at the end of the array close to a conductive pad structure. The present invention enables fabrication of wide bridges which avoid or substantially decreases likelihood of such bridge collapsing somewhere in the array such as shown in Figure 13 whilst enabling positioning of the end of the array close to a conductive pad which avoid or substantially decreases likelihood of the bridge collapsing at the end of the array as shown in Figure 14.

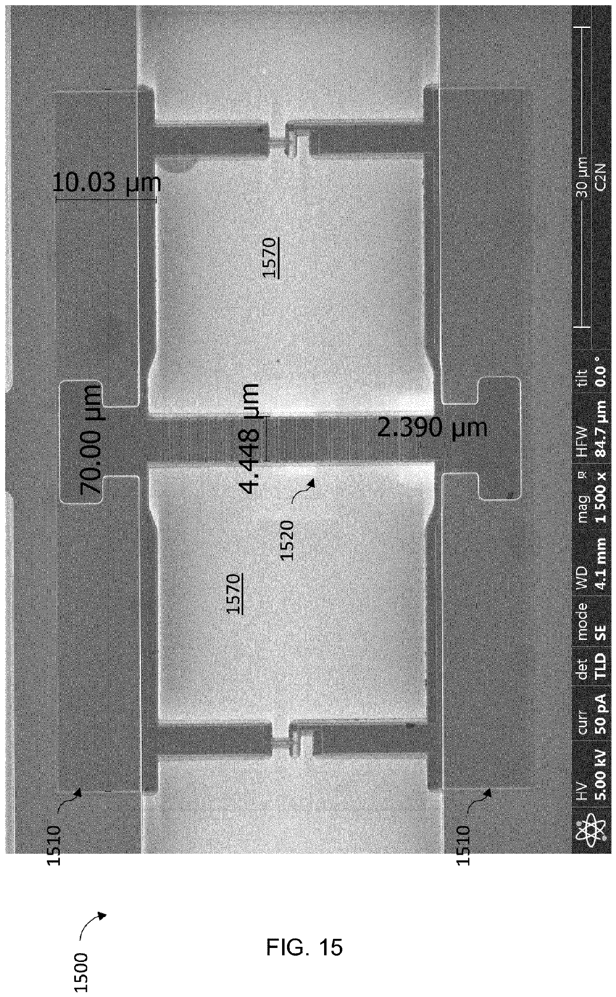

Figure 15 shows an image of a superconducting quantum circuit 1500 fabricated according to the invention which comprises a Josephson junction array 1520 comprising around 30 Josephson junctions positioned between two conductive pads 1410. In particular, circuit 1500 is an asymmetrically threaded SQUID (or ATS) suitable for nonlinear wave-mixing process (e.g. to stabilize a so-called cat qubit as described in Réglade, Ulysse, et al. "Quantum control of a cat qubit with bit-flip times exceeding ten seconds." Nature (2024): 1-6.). In particular, the present invention enables the fabricating of a higher quality superinductor (array 1520) than disclosed in the prior art whilst minimising the distance of the conductive pads 1510 from either end of the superinductor 1520. This advantageously enables fabrication of such an ATS having smaller areas of the superconducting loops (indicated by reference numerals 1570), which reduces the sensitivity of the ATS to flux noise. This example circuit is only an exemplary embodiment, and the present Inventors have recognised that the present invention can be used to fabricate arrays close to conductive pads in other superconducting circuits (such as for so-called fluxonium, etc).

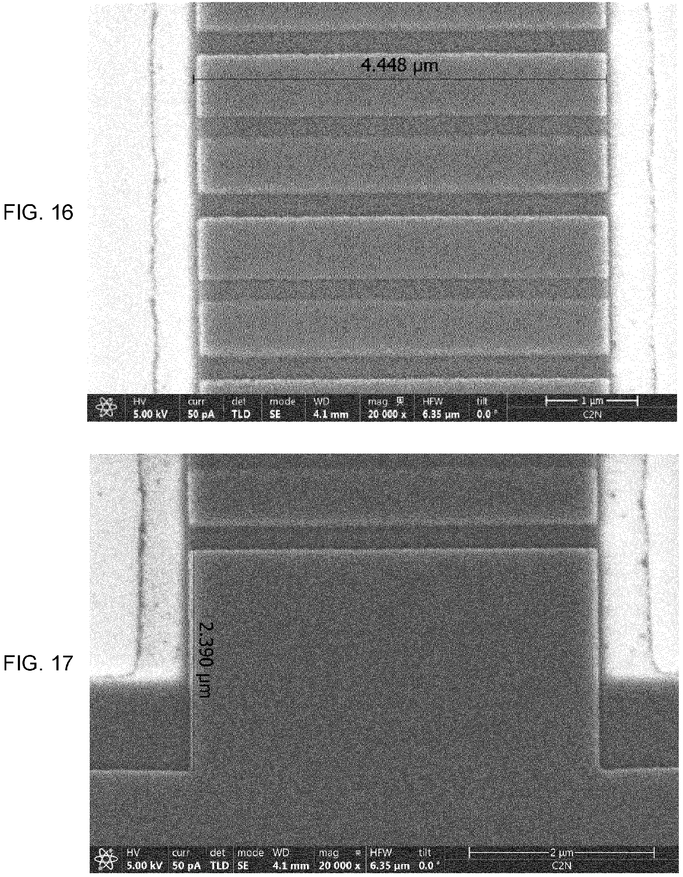

Figure 16 shows a close-up of Figure 15 towards the centre of the array 1520, and Figure 17 shows a close-up of Figure 15 at the lower end of the array 1520 close to the lower conductive pad 1510.

In the circuit 1500 of Figures 15 to17, the Josephson junction array as a width of around 4.4 µm. The ends of the array are positioned a distance of around 2.4 µm of the conductive pads 1510. The conductive pads 1510 are each around 70 µm wide and 10 µm long. The circuit 1500 of Figures 15 to17 was not possible to fabricate using bridge-like structures using the prior art methods.

## Claims

1. Method for preparing a sample (10) for manufacturing a superconducting quantum circuit comprising a Josephson junction, said sample (10) comprising a substrate layer (12) covered by an undercut resist layer (14) and a top resist layer (16), said method comprising:
- providing an undercut resist layer (14) made from an electron-beam-lithography (EBL)-insensitive selectively soluble material,
- providing a top resist layer (16) made from a positive-EBL-sensitive material on top of said undercut resist layer (14),
- receiving (200) a superconducting quantum circuit pattern (300) comprising a Josephson junction,
- determining (210) a corrected pattern (400) by applying a 2D Proximity Effect Correction to said superconducting quantum circuit pattern (300),
- projecting (220) at least 50 kV electron beam on the top resist layer (16) modulated according to said corrected pattern (400),
- developing (230) the top resist layer (16),
- developing (240) the undercut resist layer (14).

2. Method according to claim 1 in which the EBL-insensitive selectively soluble material is chosen from a group comprising LOR, PMGI, AR-BR 5400, MICROPOSIT LOL 2000 and/or MICROPOSIT LOL 1000, and wherein the positive-EBL-sensitive material is chosen from a group comprising PMMA, CSAR62, and/or ZEP.

3. Method according to claim 1 in which the EBL-insensitive selectively soluble material is made of LOR and the positive-EBL-sensitive material is made of PMMA.

4. Method according to one of the preceding claims in which projecting (220) at least 50 kV electron beam comprises using at least 100 kV electron beam.

5. Method for preparing a sample (10) according to one of the preceding claims, in which developing the top resist layer (16) comprises using one of MIBK, IPA and MIBK mixture and IPA and deionised water mixture.

6. Method according to one of the preceding claims, in which developing the undercut resist layer (14) comprises prewetting the top resist layer (16) and/or using a TMAH-based developer for precise etching.

7. Method according to one of the preceding claims, in which providing a top resist layer (16) further comprises applying a discharging layer over the top resist layer (16).

8. Method according to one of the preceding claims, further comprising depositing a superconducting layer after developing the undercut resist layer (14), optionally using a two-step angled coating process.

9. Method according to the preceding claims, in which providing an undercut resist layer (14) comprises using a primer on the substrate layer (12) and/or using a spin-coating process.

10. Method according to one of the preceding claims for preparing a sample (10) for manufacturing a superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm, a distal end of said Josephson junction array being between 0.75 µm and 50 µm from a conductive structure on the sample, wherein the conductive surface has a surface area greater than 100 µm²;

11. Method of manufacturing a superconducting quantum circuit, comprising using a sample prepared according to any of the preceding claims to fabricate Josephson junctions in a part of the superconducting quantum circuit by double angle evaporation.

12. Sample for manufacturing a superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm or greater than 5 µm, a distal end of said Josephson junction array being between 0.75 µm and 50 µm from a conductive structure on the sample, wherein the conductive surface has a surface area greater than 100 µm².

13. A superconducting quantum circuit comprising at least three Josephson junction each having been patterned using a bridge-like sample structure and arranged in series, thereby forming a Josephson junction array, wherein each of the Josephson junctions has a width in the direction perpendicular to the array axis of between 3.5 µm and 6 µm or greater than 5 µm, a distal end of said Josephson junction array being between 0.75 µm and 50 µm from a conductive structure on the sample, wherein the conductive surface has a surface area greater than 100 µm².

14. A superconducting quantum circuit according to claim 13, in which the Josephson junction array comprises between 10 and 55 Josephson junctions, the Josephson junctions are between 4 µm and 5 µm widen, and the distal end of the Josephson junction array is less than 10 µm from a conductive pad, and the conductive pad is at least 20 µm wide in direction perpendicular to an axis defined by the Josephson junction array and at least 10 µm long in direction parallel to the axis defined by the Josephson junction array.

15. A superconducting quantum circuit according to claim 13 or 14, in which said superconducting quantum circuit comprises an asymmetrically threaded SQUID (ATS) having a central superinductor comprised of said Josephson junction array.
